# EUROPÄISCHE PATENTSCHRIFT

(11) **EP 3 736 530 B1**
(45) Veröffentlichungstag und Bekanntmachung des Hinweises auf die Patenterteilung: **22.03.2023**
(21) Anmeldenummer: 19172787.4
(22) Anmeldetag: 06.05.2019
(51) Int. Cl.: G01C 15/00, G01S 1/70, G01S 3/78, G01S 5/16, G01S 17/66

(54) **AUTOMATISCHES AUFFINDEN VON ZIELMARKEN**
AUTOMATIC DETECTION OF TARGETS
RECHERCHE AUTOMATIQUE DE MARQUES CIBLES

(43) Veröffentlichungstag der Anmeldung: 11.11.2020
(73) Patentinhaber: Hexagon Technology Center GmbH, 9435 Heerbrugg (CH)
(72) Erfinder: WALSER, Andreas, 9000 St.Gallen (CH); BESTLER, Simon, 88085 Langenargen (DE)
(74) Vertreter: Kaminski Harmann

(56) Entgegenhaltungen:
- US-A1- 2008 004 808
- US-A1- 2012 327 271
- US-A1- 2016 258 752
- US-A1- 2017 122 734

## Beschreibung

Die Erfindung betrifft ein Verfahren und eine Vorrichtung zum automatischen bildbasierten Auffinden einer Zielmarke gemäss des Anspruchs 1 bzw. des Anspruchs 10.

Verfahren zum automatischen Auffinden bzw. Identifizieren von Zielmarken mittels einer optisch-elektronischen Einrichtung bzw. automatischen Zielmarkenfinders, z.B. im Rahmen einer koordinativen industriellen oder geodätischen Vermessung, sind prinzipiell aus dem Stand der Technik bekannt, z.B. aus der WO 2011/098131, aus der US 2016/258752 A1, oder der EP 0815468.

Beispiele für koordinative Vermessungsgeräte sind Tachymeter oder Lasertracker, mit welchen Punkte im Raum, welche mit der Zielmarke, z.B. als Teil eines Lotstabs, markiert sind, hochgenau vermessen werden. Eine Zielmarke kann dabei eine retro-reflektierende Einheit (z. B. Würfelprisma) aufweisen, die mit einem optischen Messstrahl der Messvorrichtung, insbesondere einem Laserstrahl, angezielt wird. Der Laserstrahl wird parallel zurück zum Vermessungsgerät reflektiert, von welcher der reflektierte Strahl erfasst wird. Hierbei wird eine Emissions- bzw. Empfangsrichtung des Strahls, beispielsweise mittels Sensoren zur Winkelmessung, die einem Ablenkspiegel oder einer Anzieleinheit des Systems zugeordnet sind, ermittelt. Zudem wird mit dem Erfassen des Strahls eine Distanz von der Messvorrichtung zum Zielpunkt, z. B. mittels Laufzeit- oder Phasendifferenzmessung, ermittelt, so dass aus Richtung und Distanz die Punktkoordinate gemessen ist. Vermessungsgeräte nach dem Stand der Technik können zusätzlich mit einer optischen Bilderfassungseinheit als Überblickskamera mit einem zweidimensionalen, lichtempfindlichen Array, z. B. einer CCD- oder CID-Kamera oder einer auf einem CMOS-Array basierenden Kamera, oder mit einem Pixelarraysensor ausgestatteten Kamera und mit einer Bildverarbeitungseinheit ausgeführt sein, wie z.B. in der WO 2005/059473 beschrieben. Das Messgerät und die Kamera können dabei insbesondere derart aufeinander montiert sein, dass ihre Positionen relativ zueinander nicht veränderbar sind. Die Kamera ist beispielsweise zusammen mit einem Lasertracker um dessen im Wesentlichen senkrechte Achse drehbar, jedoch unabhängig vom Lasertracker auf und ab schwenkbar und somit insbesondere von der Optik des Laserstrahls getrennt angeordnet. Weiter kann die Kamera - z. B. in Abhängigkeit der jeweiligen Anwendung - nur um eine Achse schwenkbar ausgeführt sein. In alternativen Ausführungen ist die Kamera in integrierter Bauweise mit der Laseroptik in einem gemeinsamen Gehäuse verbaut.

Ausserdem wird in modernen Vermessungsgeräten auf einem ortsauflösenden Sensor einer gesonderten ATR-Kamera eine Ablage des empfangenen Messstrahls von einer Nullposition ermittelt. Das Ausgangssignal des Sensors wird dabei vermittels einer oder mehrerer photosensitiver Flächen (PSD) erzeugt und hängt von der jeweiligen Position des Lichtschwerpunkts ab. Mittels einer nachgeschalteten oder integrierten Elektronik kann das Ausgangssignal ausgewertet werden und der Schwerpunkt ermittelt werden. Die Ermittlung der Position des Schwerpunkts des auftreffenden Lichtpunkts kann dabei sehr schnell und mit einer sehr hohen Auflösung erfolgen. Allerdings kann mittels der PSD nur ein Schwerpunkt der Lichtverteilung ermittelt werden, und keine Verteilung mehrerer Lichtpunkte. Mittels dieser messbaren Ablage kann eine Positionsdifferenz zwischen dem Zentrum eines Retroreflektors und dem Auftreffpunkt des Laserstrahls auf dem Reflektor bestimmt und die Ausrichtung des Laserstrahls in Abhängigkeit dieser Abweichung derart korrigiert bzw. nachgeführt werden, dass die Ablage auf dem Sensor verringert wird, insbesondere "Null" ist, und damit der Strahl in Richtung des Reflektorzentrums und damit hochgenau auf die Zielmarke ausgerichtet ist. Durch das Nachführen der Laserstrahlausrichtung kann eine fortlaufende Zielverfolgung (Tracking) der Zielmarke erfolgen und die Entfernung und Position des Zielpunkts fortlaufend relativ zum Messgerät bestimmt werden. Das Nachführen kann dabei mittels einer Ausrichtungsänderung des motorisiert bewegbaren, zur Ablenkung des Laserstrahls vorgesehenen Ablenkspiegels und/oder durch ein Schwenken der Anzieleinheit, die die strahlführende Laseroptik aufweist, realisiert werden.

Der beschriebenen Zielverfolgung muss ein Auffinden der Zielmarke vorausgehen, so dass ein Ankoppeln des Laserstrahls an den Reflektor erfolgen kann. Hierzu kann am Vermessungsgerät zusätzlich eine Erfassungseinheit mit einem weiteren positionssensitiven Sensor (PSD) mit einem verhältnismässig grossen Sichtfeld angeordnet sein. Zudem sind in gattungsgemässen Koordinatenmessgeräten zusätzliche Beleuchtungsmittel integriert, mit welchen das Ziel bzw. der Reflektor, insbesondere mit einer definierten, sich von der Wellenlänge der Distanzmessmittel unterscheidenden Wellenlänge, beleuchtet wird. Mittels der Beleuchtungsmittel kann das Ziel beleuchtet und mit der Erfassungseinheit ein Bild des Ziels mit beleuchtetem Reflektor erfasst werden. Durch die Abbildung des spezifischen (wellenlängenspezifischen) Reflexes auf dem Sensor können die Reflexposition im Bild aufgelöst und damit ein Winkel relativ zur Erfassungsrichtung der Kamera und eine Richtung zum Ziel bzw. Reflektor bestimmt werden. Eine Ausführungsform eines Lasertrackers mit einer derartigen Zielsucheinheit ist beispielsweise aus der WO 2010/148525 bekannt.

Ein wesentlicher Nachteil von herkömmlichen Zielauffindungsverfahren und Zielmarken ist insbesondere eine ungenügende Robustheit gegen eine falsche Identifikation der Zielmarke, beispielsweise im Fall von mehreren sich im Sichtfeld befindenden Zielmarken oder von reflektierenden oder selbstleuchtenden Störobjekten, welcher fälschlicherweise als Zielmarke angesehen werden. Zudem erweist sich bei einigen bekannten Systemen des Standes der Technik das aufwendige Übermitteln der Zielmarkenidentitäten von der jeweiligen Zielmarke an das Vermessungsgerät als nachteilig. Es besteht also bei Systemen des Stands der Technik, welche Zielauffindung bereitstellen, eine relativ hohe Unsicherheit ob der korrekten Zuordnung einer als Zielmarke erkannten Erfassung.

Die US 2017/0122734 offenbart ein Verfahren zum Zielmarkenauffinden bzw. -identifizieren, bei welchem in einem Bild ein Lichtmuster einer vom Ziel ausgehenden optischen Strahlung erkannt wird. Hierzu muss nachteilig das Sichtfeld des lichterfassenden Bildsensors des Vermessungsgeräts relativ zur Zielmarke bewegt werden (damit der Bildhintergrund verschmiert und dieser somit vom Lichtmuster unterscheidbar wird) und die Belichtungszeit des einen Bilds an das Lichtmuster angepasst werden. Zudem ist mit dem dort vorgestellten Verfahren ein Auffinden eines sich relativ zum Vermessungsgerät und damit Bildsensor bewegenden Ziels schwierig oder gar unmöglich.

Es ist daher eine Aufgabe der vorliegenden Erfindung, ein verbessertes Verfahren zum automatischen Auffinden von Zielmarken bereitzustellen.

Speziell kann dabei eine robustere und/oder schnellere Erfassung von Zielmarken, insbesondere von mehreren Zielmarken in der Messumgebung, angestrebt werden.

Diese Aufgabe wird durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen sowie der Beschreibung einschliesslich der Figurenbeschreibungen zu entnehmen. Alle dargestellten oder in dieser Schrift anderweitig offenbarten Ausführungsformen der Erfindung sind miteinander kombinierbar, wenn nicht ausdrücklich anders festgestellt.

Die Erfindung betrifft ein Verfahren zum automatischen Auffinden von wenigstens einer Zielmarke. Im Rahmen des Verfahrens erfolgt ein Emittieren von Strahlung von der Zielmarke, wobei die Strahlung mittels Modulation, insbesondere Phasenmodulation, wiederholt eine charakteristische Signatur aufweist.

Weiter erfolgt ein Aufnehmen einer ersten Bildersequenz mit einer ersten Bildrate, um Zielmarkenstrahlung zu erfassen, z.B. mittels einer Zielauffindungskamera eines Vermessungsgerätes, welches mit der Zielmarke ein Vermessungssystem bildet.

Als weitere Schritte erfolgen ein statistisches Auswerten der ersten Bildersequenz in Kenntnis der Signatur mit Berechnen einer Gütefunktion, wobei der Wert der Gütefunktion eine Wahrscheinlichkeit dafür angibt, dass in einem jeweiligen Bildpunkt Zielmarkenstrahlung erfasst ist, und ein Identifizieren von Bildpunkten, mit denen wahrscheinlich Zielmarkenstrahlung erfasst ist, basierend auf dem (zum Bildpunkt zugehörigen) Wert der Gütefunktion. Mittels einer auf die bekannte Signatur bezogene Gütefunktion werden also in einer ersten Serie von Bildern Bildpunkte ermittelt, welche mit einer bestimmten Wahrscheinlichkeit Zielmarkenstrahlung registriert haben.

Weiter erfolgt im Rahmen des Verfahrens ein Aufnehmen einer zweiten Bildersequenz mit einer zweiten, zur ersten Bildrate unterschiedlichen, vorzugweise (sehr viel) höheren, Bildrate, und ein Auswerten von Intensitätssignalen der zweiten Bildersequenz für besagte identifizierte Bildpunkte. Anhand dieser Intensitätssignale wird basierend auf der Signatur Zielmarkenstrahlung identifiziert. Mit anderen Worten wird also zusätzlich eine weitere Serie von Bildern mit einer anderen Bildrate aufgenommen und daraus für die zuvor anhand der Gütefunktion identifizierten, für eine nähere oder weitere Untersuchung in Frage kommenden Bildpunkte anhand der Intensität eine Übereinstimmung mit der hinterlegten Signatur getestet.

Dieses zweistufige Verfahren ermöglicht unter anderem, eine vergleichsweise niedrige Schwelle in der ersten Teststufe (also anhand der ersten Bildersequenz) zu setzen, so dass sichergestellt ist, dass jedenfalls alle Zielmarkenstrahlung positiv klassifiziert wird und keine Zielmarke "übersehen" wird oder fälschlicherweise "aussortiert" wird. Beispielsweise gelten als identifizierte Bildpunkte bereits solche, bei welchen der Wert der Gütefunktion (bzw. einer daraus ermittelten Wahrscheinlichkeit) eine Mindestwahrscheinlichkeit von nur 50% für Zielmarkenstrahlungserfassung indiziert (es wird also sozusagen eine Unsicherheit von 50% akzeptiert). Wegen der zweiten, detaillierteren Teststufe kann dabei in Kauf genommen werden, dass auch Nicht-Zielmarkenstrahlung (vorläufig) als Zielmarkenstrahlung klassifiziert wird, da diese dann anhand der zweiten Bildersequenz korrekt aussortiert wird und am Schluss nur echte Zielmarkenstrahlung als solche identifiziert wird.

Die Ausgestaltung einer solchen Gütefunktion, mit welcher von Zielmarkenstrahlung herrührende Signaländerungen von solchen von anderen Lichtquellen unterschieden werden können, hängt insbesondere von der Kombination von Bildaufnahmerate während dieser ersten Bildersequenz und den Modulationsfrequenzen der Zielmarkenstrahlung ab. Beispielsweise kann die Zielmarkenstrahlung so gewählt werden, dass sich ein charakteristisches digitales Modulationsmuster mit der Bildaufnahmerate während dieser ersten Bildersequenz wiederholt aber das Muster abwechslungsweise invertiert gesendet wird. In der aufgenommenen Bildersequenz weisen Bildpunkte, die zu Zielmarken gehören, abwechslungsweise ein hohes und im darauffolgenden Bild ein niedriges Signal auf. Bildpunkte, die nicht zu Zielmarken gehören, zeigen eine solche Signatur nur mit weit geringerer Wahrscheinlichkeit. Die Gütefunktion kann in diesem Fall eine statistische Funktion sein, die den Signalverlauf eines Bildpunktes innerhalb der aufgenommenen Bildsequenz mit dem idealen, theoretischen Signalverlauf, der der Erfassung der charakteristischen Zielmarkenstrahlung mit der verwendeten Bildaufnahmerate entspricht, vergleicht.

Optional erfolgt dabei das Aufnehmen der zweiten Bildersequenz mit einem zweiten Sichtfeld, welches kleiner ist als ein erstes Sichtfeld des Aufnehmens der ersten Bildersequenz, wobei sich eine Lage des mindestens einen zweiten Sichtfelds nach dem jeweiligen besagten Bildpunkt richtet, insbesondere wobei das mindestens eine zweite Sichtfeld einer Bildpunktregion, beispielsweise von etwa 20x20 Bildpunkten, um einen jeweiligen identifizierten Bildpunkt entspricht.

Durch die beiden Auswertestufen kann also zum einen mit dem ersten Sichtfeld ein grosser Umgebungsbereich für die Zielauffindung abgedeckt werden, zum anderen ist mit dem kleineren zweiten Sichtfeld (Beschränkung der Anzahl aktiver Pixel des Bildsensors) ermöglicht, dass das zweite Aufnehmen mit einer sehr hohen Bildrate erfolgen kann, ohne dass hierzu besonders hohe Anforderungen an die Bildaufnahmevorrichtung (Bildverarbeitungskapazitäten) gestellt werden müssen. Beispielsweise lassen sich so beide Bildersequenzen mit einer herkömmlichen Digitalkameras aufnehmen, welche kleine Bildausschnitte mit Raten im Bereich von Kilohertz erzeugen, jedoch Vollbilder nur mit einer deutlich kleineren Rate aufnehmen können.

Vorzugsweise erfolgt das Auswerten der ersten und/oder zweiten Bildersequenz mittels Differenzbildern. Es werden also Bilder einer jeweiligen Bilderserie miteinander abgeglichen und damit sozusagen der zeitliche Werteverlauf eines jeweiligen Bildpunkts ermittelt. Durch bildpunktweises Bilden von Differenzen der jeweiligen Werte von zeitlich unmittelbar benachbarten Bildern entsteht für jeden Bildpunkt ein auf Differenzbildern basierender Werteverlauf, der Bildpunkte mit während der Bildsequenzdauer variierenden Werten gegenüber zeitlich statischen stärker hervorhebt. Diese Auswertung im Hinblick auf die Signatur basierend auf Differenzbildern ist somit für die Erkennung von modulierter Zielmarkenstrahlung vorteilhaft.

Optional weist die Signatur im Frequenzraum einen ersten, auf die erste Bildrate abgestimmten, spektralen Anteil und einen zweiten, auf die zweite Bildrate abgestimmten Anteil auf. Alternativ oder zusätzlich weist die Signatur im Zeitbereich einen Start- und/oder Endindikator auf (also einen Signaturanteil, welcher zur Signalisierung des Beginns und/oder des Endes der Signatur dient).

Als weitere Option erfolgt das Aufnehmen der ersten und/oder zweiten Bildersequenz über eine Zeitdauer, in welcher die Signatur vielfach wiederholend emittiert wird. Es werden also mindestens über einer Zeitdauer Bilder einer jeweiligen Bilderserie aufgenommen, welches einem Vielfachen der Abfolge der Signatur (inklusive eventuell eingestellter Pausen zwischen zwei Wiederholungen) entspricht.

Als weitere Option weist die Strahlung eine Wellenlänge im nahinfraroten IR-A-Bereich auf, z.B. beträgt die Strahlungswellenlänge 850nm. Alternativ oder zusätzlich dient die Zielmarkenstrahlung zur Datenübertragung, so dass z.B. eine kleine Anzahl an Nutzdaten von der Zielmarke an ein weiteres Gerät übertragbar ist.

Optional ist die zweite Bildrate mindestens zehnmal so hoch wie die erste Bildrate, wobei die erste Bildrate beispielsweise im Bereich zwischen 45Hz und 65Hz liegt und/oder die zweite Bildrate mindestens 1kHz, insbesondere mindestens 2kHz beträgt.

Als weitere bevorzugte Option erfolgt das Aufnehmen der ersten und zweiten Bildersequenz synchronisationslos zum Emittieren der Zielmarkenstrahlung. Das Aufnehmen einer jeweiligen Bildersequenz kann also optional z.B. zu jedem Zeitpunkt gestartet werden, ohne Rücksicht auf das Starten der Emission der Zielmarkenstrahlung nehmen zu müssen (und umgekehrt), wobei optional das Emittieren durch ein externes Kommunikationssignal, beispielsweise optisch oder via Radiofrequenz, gestartet wird. Alternativ kann die Zielmarke aber auch zusätzlich zur modulierten Zielmarkenstrahlung auf einem weiteren, von der Zielmarkenstrahlung getrennten bzw. unabhängigen Kommunikationskanal, beispielsweise auf einer definierten Radiofrequenz, Synchronisationssignale senden. So kann die Kamera mittels dieser weiteren Signalübertragung synchronisiert die Zielmarkenstrahlung erfassen.

In einer Fortbildung des Verfahrens wird mittels der ersten und/oder zweiten Bildersequenz anhand jeweiliger identifizierter Bildpunkte eine Richtung (z.B. in Form von Polar- und Azimutwinkel) zur Zielmarke bestimmt, wobei optional zudem eine Abweichung der Richtung von einer Sollrichtung (z.B. Null- oder Zentralrichtung) bestimmt wird.

In einer Fortbildung des Verfahrens erfolgt im Rahmen des Verfahrens anhand der identifizierten Bildpunkte, für welche Zielmarkenstrahlung identifiziert ist, eine automatische Verfolgung (Tracking) der Zielmarke anhand der identifizierten Zielmarkenstrahlung.

Die Erfindung betrifft zudem einen Zielmarkenfinder mit einer Auswerteelektronik und einem, z.B. in eine Digitalkamera integrierten, ortsauflösenden optoelektronischen Sensor, beispielsweise ausgebildet als CCD- oder CMOS-Sensor, als zweidimensionaler Photodetektorenarray oder als Dynamic Vision Sensor, zur Erfassung von eine bekannte charakteristische Signatur aufweisender Zielmarkenstrahlung.

Der Zielmarkenfinder ist ausgebildet, mittels des Sensors eine erste Bildersequenz mit einer ersten Bildrate aufzunehmen und mittels der Auswerteelektronik die erste Bildersequenz statistisch auszuwerten. Im Rahmen der statistischen Auswertung wird eine Gütefunktion bestimmt, deren Wert eine Wahrscheinlichkeit dafür angibt, dass in einem jeweiligen Bildpunkt Zielmarkenstrahlung erfasst ist, wozu in der Auswerteelektronik die Signatur hinterlegt ist, und basierend auf der Gütefunktion Bildpunkte zu identifizieren, mit denen wahrscheinlich Zielmarkenstrahlung erfasst ist.

Weiter ist der Zielmarkenfinder ausgebildet, mittels des Sensors eine zweite Bildersequenz mit einer zweiten, zur ersten Bildrate unterschiedlichen, insbesondere höheren, Bildrate aufzunehmen und mittels der Auswerteelektronik Intensitätssignalen der zweiten Bildersequenz für besagte identifizierte Bildpunkte auszuwerten und Zielmarkenstrahlung anhand der Intensitätssignale basierend auf der hinterlegten Signatur zu identifizieren.

Dabei weist der Zielfinder, welcher als separate Einheit oder in ein Vermessungsgerät, z.B. ein Tachymeter oder ein Lasertracker, integriert ausgebildet sein kann, optional einen abschaltbaren Langpassfilter und/oder ein nahinfrarotkorrigiertes Objektiv auf. Als weitere Option ist der Sensor Teil einer Überblickskamera eines solchen Vermessungsgeräts.

Optional ist die Auswerteelektronik ausgebildet, anhand einer Position eines identifizierten Bildpunkts auf dem Sensor eine Richtung zur Zielmarke zu ermitteln. Vorzugsweise ist das Auswertemodul dabei derart ausgebildet, anhand einer Ablage von einer Bildpunktnullposition eine Ausrichtung des Zielmarkenfinders, insbesondere fortlaufend, zu steuern, so dass die Ablage verringert wird, insbesondere Null ist.

Die Erfindung betrifft zudem ein Vermessungssystem mit einem Zielmarkenfinder und mit einer Zielmarke mit einer modulierbaren, insbesondere nahinfraroten, Strahlquelle, vorgesehen zur Emission von Zielmarkenstrahlung, wobei die Zielmarkenstrahlung mittels Modulation, insbesondere Phasenmodulation, wiederkehrend eine charakteristische, insbesondere mehrstufige, Signatur aufweist.

Darüberhinaus betrifft die Erfindung ein Vermessungssystem mit einem erfindungsgemässen Zielmarkenfinder und einer erfindungsgemässen Zielmarke.

Die Erfindung kann dabei zumindest teilweise von einer elektronischen Steuer- und Auswerteeinheit ausgeführt werden, welche zumindest teilweise programmierbar ist, beispielsweise mit einem Digitalrechner oder vergleichbaren Komponenten. Daher betrifft die vorliegende Erfindung auch eine Ausführungsform in Form eines Computerprogrammprodukts mit Programmcode, welcher auf einem physikalischen Datenträger gespeichert oder als elektromagnetische Welle (z.B. als mittels Funk übertragenes Datensignal) bereitgestellt wird, und zur Ausführung auf einem Digitalrechner ausgebildet ist.

Die Erfindung bietet also den Vorteil einer robusten, zuverlässigen automatischen Zielmarkenauffindung, wobei unterschiedliche Zielmarken eindeutig identifiziert werden. Mittels der zumindest zwei unterschiedlichen Auswertestufen (also z.B. ein erster Grobselektionsschritt und ein zweiter Feinselektionsschritt) werden einerseits zuverlässig alle Zielmarken in der Umgebung erfasst, andererseits fehlerhafte Identifikationen vermieden. Durch die verschiedenen Bildraten kann ein quasi-synchrones Sampling bereitgestellt werden, ohne echt synchronisieren zu müssen, insbesondere bei Ausführungsformen mit einer mehrstufigen Signatur, welche also einen Codeanteil aufweist, der auf die erste Bildrate abgestimmt ist, und einen weiteren Codeanteil, welcher auf die zweite Bildrate abgestimmt ist. Alternativ können bei Ausführungsformen mit einem unabhängigen, zusätzlichen Synchronisationskanal, wie weiter oben dargestellt, Bilder mit Hilfe dessen auch echt synchron erfasst werden.

Ein weiterer Vorteil des robusten kamerabasierten Erkennens von leuchtenden Zielmarken durch Analyse deren gesendeten Signale bei unterschiedlichen Kamerabildraten ist, dass ein grosses Sichtfeld bereitgestellt werden kann (z.B. mit der ersten Bilderserie), so dass ein grosser Umgebungsbereich abgedeckt ist und auch ein schnelles Wiederfinden einer Zielmarke ermöglicht ist. Beispielsweise lassen sich damit auch Ziele während kontinuierlicher Bewegung des Zielfinders auffinden. Zum Beispiel lässt sich das Verfahren mit einer herkömmlichen Überblickskamera, z.B. eines Vermessungsgeräts, implementieren.

Dabei werden bei einer gezielten Beschränkung des zweiten Sichtfelds auf im ersten Verfahrensabschnitt identifizierte Bildpunkte bzw. Regions of Interest das Bilddatenaufkommen und damit der Prozessierungsaufwand vorteilhaft gering gehalten. Zudem ermöglicht die Verwendung von Differenzbildern eine weitere Beschleunigung des Prozessierens sowie eine erhebliche Reduktion des benötigten Speicherbedarfs im Vergleich zur Verwendung der unmittelbar aufgenommenen Bilder.

Das erfindungsgemäße Verfahren und die erfindungsgemäße Vorrichtung werden nachfolgend anhand von, in den Zeichnungen schematisch dargestellten, konkreten Ausführungsbeispielen rein beispielhaft näher beschrieben, wobei auch auf weitere Vorteile der Erfindung eingegangen wird.

Im Einzelnen zeigen:
Fig. 1 eine schematische Darstellung einer Ausführungsform der vorliegenden Erfindung mit einem geodätischen Vermessungsgerät mit automatischem Zielmarkenfinder zum Identifizieren einer Zielmarke;
Fig. 2 beispielhaft einen Ablauf eines erfindungsgemässen Zielauffindungsverfahrens;
Fig. 3a, 3b und 3c eine weitere exemplarische Darstellung eines erfindungsgemässen Zielauffindungsverfahrens; und
Fig. 4 eine weitere Fortbildung des erfindungsgemässen Zielauffindungsverfahrens.

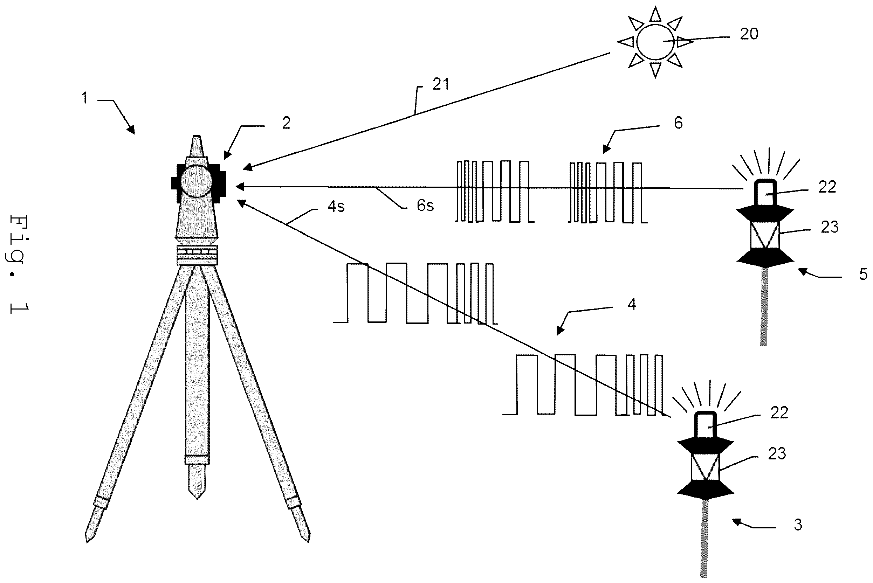

Figur 1 zeigt schematisch ein Vermessungsgerät 1, z.B. ein Theodolit oder eine Totalstation, mit einem automatischen Zielmarkenfinder 2, sowie zwei Zielmarken 3 und 5, mit welchem Zielpunkte in der Messumgebung, z.B. zur geodätischen Vermessungszwecken, markierbar sind. Im Beispiel weisen die Zielmarken 3, 5 hierzu Retroreflektoren 13 auf, welche vom Vermessungsgerät 1 mittels eines nicht dargestellten Messstrahls anvisiert und vermessen werden können, so dass Richtung (anhand der Visierrichtung) und Distanz (z.B. durch Laufzeitmessung oder Phasendifferenzmessung) zum Retroreflektor 23 und damit zum Ziel hochgenau bestimmt werden können.

Zum Vermessen muss der Messstrahl erst einmal auf die Zielmarke 3, 5 ausgerichtet werden, diese also aufgefunden werden. Dies kann manuell durch einen Benutzer erfolgen, was relativ zeitaufwändig ist, oder bei manchen Vermessungsgeräten des Stands der Technik automatisch, z.B. mittels grossräumiger Beleuchtung mit Zielsuchstrahlung und deren Detektion mit einer optischen Abbildungseinheit mit grossem Sichtfeld. Die optische Abbildungseinheit ist z.B. als Kamera ausgebildet, welche entweder relativ zu einem Teleskop des Vermessungsgeräts 1 fest fixiert oder frei um eine oder zwei Achsen schwenkbar ist, wobei die relativen Winkel zwischen Blickrichtung der Kamera und des Teleskops gemessen werden. Zentral ist dabei, dass für jeden Bildpunkt der Kamera zugehörige Offsetwinkel zur Blickrichtung des Teleskops berechnet werden können.

Problematisch hierbei ist u.a., dass beim gezeigten Vorhandensein von mehreren Zielmarken 3, 5 in der Messumgebung das Vermessungsgerät 1 nicht unterscheiden kann, welche Zielmarke 3 oder 5 aufgefunden ist. Zudem können auch unter Umständen Fremdlichtquellen 20, welche Fremdstrahlung 21 emittieren, fälschlicherweise als Zielmarke registriert werden. Somit kommen mit Verfahren des Stands der Technik Verwechslungen vor, wodurch z.B. vermessene Punkte falsch zugeordnet werden. Zwar sind zur eindeutigen Identifizierung von Zielmarken 3, 5 Techniken aus dem Stand der Technik bekannt, diese sind jedoch nicht ausreichend robust bzw. erfordern unverhältnismässigen zusätzlichen Aufwand.

Mit der vorliegenden Erfindung wird ein Verfahren vorgeschlagen, in welchem von einer jeweiligen Zielmarke 3, 5 Zielmarkenstrahlung 4a, 6a ausgeht, welche derart moduliert ist, dass diese wiederholt eine für die jeweilige aktive Zielmarke 3, 5 charakteristische Signatur 4, 6 aufweist, wobei vorteilhaft jeweils eine phasencodierte Signatur 4, 6 verwendet wird, um den Einfluss von Amplitudenfluktuation und/oder Strahlungsunterbrechungen zu minimieren. Hierzu weist eine jeweilige Zielmarke 3, 5 wie dargestellt z.B. eine Lichtquelle 22 auf, beispielsweise eine Hochleistungs-LED mit grossem Abstrahlwinkel. Die Wellenlänge der Zielmarkenstrahlung 4s, 6s liegt vorzugsweise im nahinfraroten Bereich, z.B. beträgt sie 850nm. Das Emittieren der Zielmarkenstrahlung 4s, 6s wird dabei von einem Benutzer an der Zielmarke 3, 5 gestartet oder per Fernsteuerung z.B. vom Vermessungsgerät 1 aus, also durch ein für die Zielmarke 3, 5 externes Kommunikationssignal.

Der Zielmarkenfinder 2 ist erfindungsgemäss derart ausgebildet, dass mittels eines ortsauflösenden optoelektronischen Sensors und einer Auswerteeinheit (hier nicht dargestellt), Umgebungsstrahlung erfasst wird. Im Beispiel einer Ausführungsform kann unter anderem etwa ein handelsüblicher Kamerachip 12 (z.B. mit einem CCD- oder CMOS-Matrix-Bildsensor) angewandt werden (bzw. eine ggf. für NIR empfindliche RGB-Kamera), welcher beispielsweise mit ca. 10 Megapixel und einem Sichtfeld von ca. 4 mm mal 5 mm eine Auflösung von etwa 1.4pm/Pixel bereitstellt. Bei einer erfindungsgemässen Zielauffindungskamera handelt es sich also z.B. um eine schnelle CCD- oder CMOS-Kamera mit oder ohne (modifizierter) Bayer-Maske. Alternativ ist der Sensor als zweidimensionaler Photodetektorenarray ausgebildet oder als Dynamic Vision Sensor (ereignisbasierte Kamera). Alternativ zur Darstellung ist der Zielmarkenfinder eine separate bzw. separierbare Einheit.

Optional weist der Zielmarkenfinder 2 bzw. eine Kamera des Zielmarkenfinders 2 einen abschaltbaren Langpassfilter auf. Als weitere Option weist das Gerät 2 ein nahinfrarotkorrigiertes Objektiv auf. Auch kann es sich bei einer Zielmarkenfinderkamera um eine Überblickskamera handeln, z.B. um die gleiche Überblickskamera, wie sie bei manchen Vermessungsgeräten 1 des Stands der Technik ohnehin vorhanden ist. Als weitere Option weist die Zielmarkenstrahlung 4s, 6s neben der Signatur 4, 6 zudem Nutzdaten auf, z.B. Informationen über die Zielmarke oder Sensordaten), welche vom Vermessungsgerät 1 auslesbar sind. D.h. die Strahlung 4s, 6s kann neben der Identifizierung mittels Signatur auch zur Datenübertragung dienen.

Mit dem Sensor erfasste Strahlung wird derart, z.B. mittels eines Bildverarbeitungssystems oder Auswertelektronik, ausgewertet, dass eine jeweilige Zielmarkenstrahlung 4s, 6s anhand der eindeutigen, der Auswerteeinheit bekannten Signatur 4, 6 zuverlässig erkannt und damit die Zielmarkenstrahlung 4s, 6s bzw. die Zielmarke 3, 5 zuverlässig identifiziert wird und damit z.B. auch Fremdlichtstrahlung 21 bzw. ein Fremdkörper 20 sicher aussortiert wird. Das erfindungsgemässe Verfahren wird anhand der nachfolgenden Figuren beispielhaft näher erläutert.

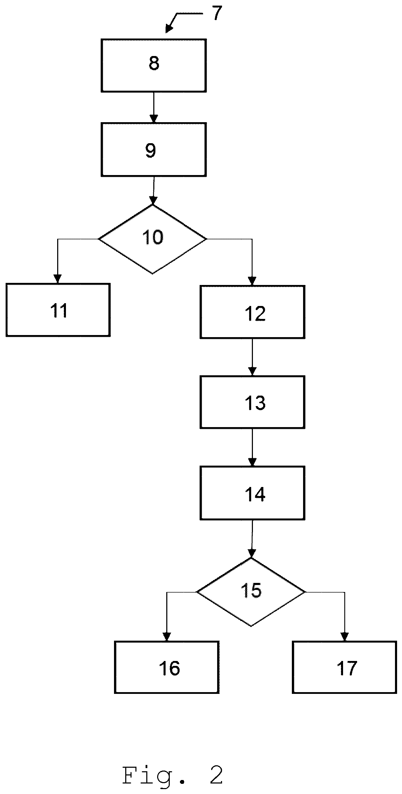

Figur 2 zeigt beispielhaft einen Ablauf des Verfahrens 7 zum Auffinden einer Zielmarke 3, 5 anhand deren Strahlung 4s, 6s bzw. genauer anhand der damit übermittelten eindeutigen Signatur 4, 6 (vgl. Figur 1).

In einem Schritt 8 wird eine erste Bilderserie aufgenommen, welches mit einer ersten Bildrate erfolgt. Die erste Bildrate beträgt z.B. 45 oder 65 Hz, was vorteilhaft hinsichtlich Zielmarkenstrahlung ist, welche mit netzbetriebenen Lichtquellen erzeugt wird. Vorzugsweise sind erste Bildrate und Signatur der Zielmarkenstrahlung aufeinander abgestimmt, indem die Modulationsrate der Strahlung an die erste Bildrate angepasst ist. Bevorzugt dauert das Aufnehmen der ersten Bilderserie derart lange, dass sichergestellt ist, dass die wiederkehrend abgestrahlte Signatur auch mehrfach/wiederholt erfasst ist. Die folgende Zielmarkenauffindung wird durch mehrfache Detektion der Signalsequenz robuster.

Bilder der ersten Bildersequenz werden im Schritt 9 analysiert. In dieser ersten Auswertestufe erfolgt ein statistisches Auswerten von Bildpunkten, wobei eine Gütefunktion bestimmt wird im Hinblick auf eine jeweilige bekannte Signatur der Zielmarkenstrahlung. Der Wert der Gütefunktion für einen jeweiligen Bildpunkt gibt eine Wahrscheinlichkeit dafür an, dass mit diesem Bildpunkt Zielmarkenstrahlung erfasst ist. Es wird also im Schritt 10 statistisch anhand mehrerer hintereinander aufgenommener Bilder getestet, ob ein bzw. welche(r) Bildpunkt(e) einen der hinterlegten Signatur entsprechenden Signalverlauf aufweist. Im Beispiel steht Symbol 11 für Bildpunkte, welche wahrscheinlich keine Zielmarkenstrahlung erfasst haben, und Symbol 12 für Bildpunkte, bei welchem das Testergebnis bzw. der Wert der Gütefunktion dafür spricht, dass der zeitliche Verlauf des Pixelsignals von der Signatur herrührt und also mit ihnen Zielmarkenstrahlung erfasst ist.

Dabei wird vorzugsweise bei dieser ersten Teststufe 10 eine relativ hohe Unsicherheit zugelassen, also auch solche Bildpunkte in die Zielmarkenstrahlungsklasse 12 zugelassen, welche z.B. nur mit einer Wahrscheinlichkeit von 50% positiv getestet sind. Ziel in dieser Auswertestufe ist vorrangig, dass keine Zielmarkenstrahlung "verloren" geht. Die Schwelle der Güte wird deswegen niedrig gewählt, so dass alle Zielmarken in der Messumgebung erkannt werden. Dafür wird in diesem Schritt in Kauf genommen, dass möglicherweise auch manche Artefakte, z.B. Störstrahlung 21 (s. Figur 1), fälschlicherweise als "positiv" getestet werden, d.h. Bildpunkte als Zielmarkenstrahlung erfassend identifiziert, obwohl dies tatsächlich nicht der Fall ist.

Zur robusten Klassifizierung der Zielmarken, also zum Ausschliessen von als mögliche Zielmarken klassifizierten Artefakten, wird in einem Schritt 13 eine weitere Bildserie mit einer unterschiedlichen, vorzugsweise mit einer erheblich erhöhten Bildrate (z.B. 10mal die erste Bildrate und/oder im Bereich von einigen Kilohertz), aufgenommen. Auch hier sind vorzugsweise Bildrate und Signatur aufeinander abgestimmt, wozu die Signatur beispielsweise einen auf die erste Bildrate abgestimmten Anteil und einen auf die zweite Signatur abgestimmten Anteil aufweist.

Anschliessend erfolgt ein Auswerten (Schritt 14) von Intensitätssignalen der zweiten Bildersequenz (zumindest) für jene Bildpunkte, die in der ersten Auswertestufe als Zielmarkenbildpunkte identifiziert sind. Das Intensitätssignal des Bildpunkts wird im Schritt 15 auf Übereinstimmung mit einer hinterlegten Signatur geprüft und bei positiver Bewertung wird bestätigt (Feld 17), dass der Bildpunkt tatsächlich Zielmarkenstrahlung erfasst hat und die entsprechende Zielmarke ist damit identifiziert und aufgefunden. Ansonsten wird der Bildpunkt als Artefakt klassifiziert bzw. verworfen (Feld 16). Eine vorzugsweise hohe Bildrate mit mehreren hundert oder tausend Hertz ermöglicht das Erstellen eines detaillierten Intensitätssignals, so dass mit hoher Sicherheit beim zweiten Test 15 Strahlungssignatur von Nicht-Signatur unterschieden werden kann.

Vorteilhaft ist, dass aufgrund der ersten Teststufe 10 das Aufnehmen der zweiten Bildersequenz auf die identifizierten Bildpunkte beschränkbar ist. D.h. die als "Zielmarkenstrahlungskandidaten" in Frage kommenden Bildpunkte, welche im ersten Verfahrensteil ermittelt sind, dienen optional als (Zentrum einer) Region of Interest, für die (und nur für die) dann die zweite Bildserie aufgenommen wird.

Die Bilder der zweiten Bildersequenz werden mit einem verengten Sichtfeld aufgenommen, welches kleiner ist als das erste Sichtfeld der ersten Bildersequenz (das erste Sichtfeld ist vorzugsweise das maximale Sichtfeld des Bildsensors bzw. des Zielauffinders, z.B. 5 Megapixel, damit ein möglichst grosser Umgebungsbereich abgedeckt ist und/oder möglichst alle vorhandenen Zielmarken erfasst werden). Die Lage des zweiten Sichtfelds richtet sich dabei nach einem jeweiligen anhand der ersten Bilderserie ausgewählten Bildpunkts. Die identifizierten Bildpunkte legen also z.B. fest, wo im Bild der Ausschnitt (im Vergleich zu den ersten Bildern) liegt. Der Ausschnitt kann sich dabei auf den oder die identifizierten Bildpunkte beschränken oder es wird ein Pixelbereich um solche Bildpunkte herum aufgenommen, z.B. ein Bereich (oder Region of Interest) von 20x20 Bildpunkten.

Vorteilhaft an einem solchen kleinen zweiten Sichtfeld ist, dass damit erheblich weniger Daten anfallen im Vergleich zu einem Vollbild. Somit ist ein schnelleres Prozessieren ermöglicht bzw. die Bildrate für die zweite Bilderserie kann noch weiter gesteigert werden, was für ein robustes Erkennen der Zielmarkenstrahlung vorteilhaft sein kann. Beispielsweise lassen sich so im Hinblick auf Abstimmung von Modulationsrate und Bildrate Signaturen mit "hoher" Modulation verwirklichen, welche robuster identifizierbare Signaturen ermöglichen.

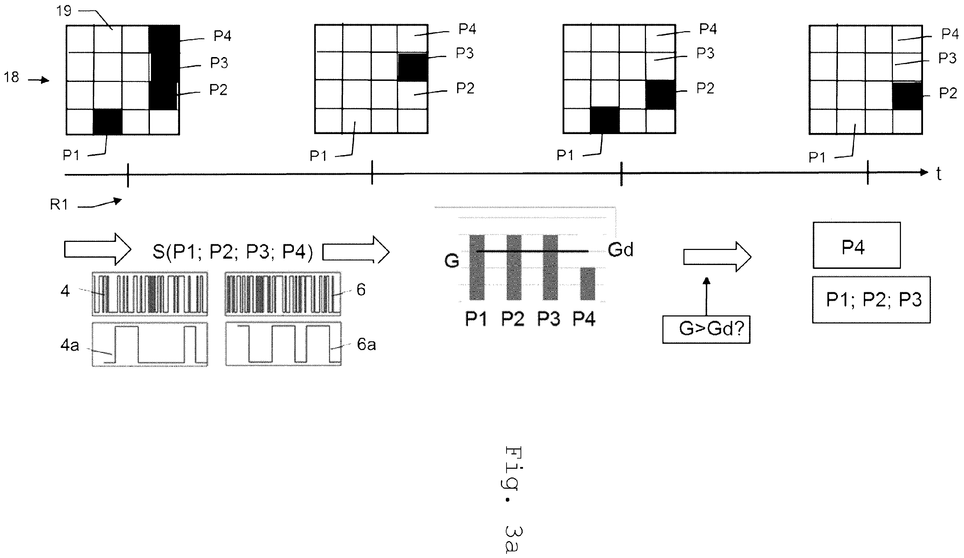

Figuren 3a-3c zeigen eine weitere exemplarische Darstellung eines erfindungsgemässen Zielauffindungsverfahrens.

In Figur 3a (oben) ist entlang einer Zeitachse t eine mit einer ersten Bildrate R1 erstellten ersten Bildsequenz 18 dargestellt, wobei die einzelnen Bilder 19 im Beispiel Differenzbilder sind, welche pixelweise aus jeweils zwei oder mehr nacheinander aufgenommenen Bildern erstellt sind. In den ersten Differenzbildern 19, die sich durch die Differenzbildung der mit dem Bildsensor aufgenommenen Bilder ergeben, sind beispielhaft vier Bildpunkte P1-P4 gekennzeichnet, deren Signale S näher betrachtet werden sollen (wobei ein Wechsel schwarz-weiss eine Differenz illustrieren soll). Die restlichen Bildpunkte sind im Beispiel auch belichtet worden, es wird aber der Einfachheit halber angenommen werden, dass diese übrigen Bildpunkte im betrachteten Zeitraum der Bilderserie gar keine Veränderungen zeigen).

Im unteren Teil der Figur 3a ist symbolhaft dargestellt, dass die Signale S der Pixel P1-P4 im Hinblick auf die bekannten Signaturen 4, 6 analysiert werden und für einen jeweiligen Bildpunkt P1-P4 eine Gütefunktion G abgeleitet wird. Anhand der Gütefunktion G wird geprüft, ob ein jeweiliger Pixel (wahrscheinlich) Zielmarkenstrahlung erfasst hat. Im Beispiel wird hierzu getestet, ob die Gütefunktion einen definierten Schwellwert Gd überschreitet oder nicht. Im Beispiel zeigt das detektierte Signal für den Bildpunkt P4 keine ausreichende Übereinstimmung (Ähnlichkeit) mit einer der beiden Signaturen und wird deshalb als Artefakt klassifiziert. Die anderen drei Bildpunkte P1-P3 hingegen werden anhand ihres Werts der Gütefunktion G in die Klasse "Zielmarkenstrahlung" eingeordnet und als Pixel P1-P3 identifiziert, welche Zielmarkenstrahlung (vermutlich) erfasst haben. Wie oben bereits geschildert, wird hierbei die Schwelle für die Klasse "Zielmarkenstrahlung" niedrig angesetzt, um sicher jegliche Zielmarkenstrahlung einzuschliessen, und entsprechend die Klassifizierung als "grobe" oder vorläufige Klassifizierung angesehen.

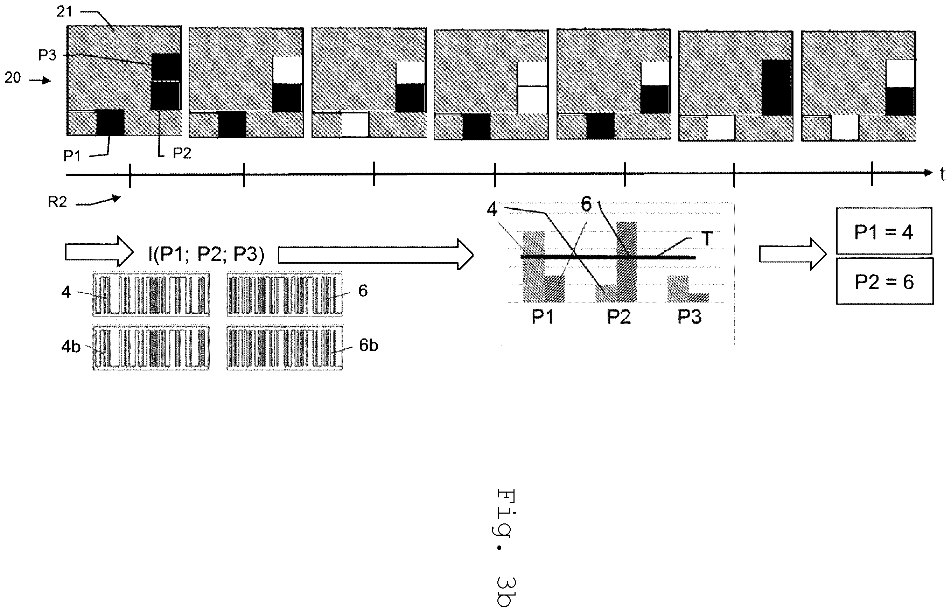

In der Figur 3b (oben) ist illustriert, wie nun für die drei in die zweite "Runde" gekommenen Bildpunkt"kandidaten" P1-P3 eine zweite Bildersequenz 20 erstellt wird, im Beispiel wiederum in Form von Differenzbilder 21. Dabei wird wie durch die Schraffur dargestellt nicht das maximale Sichtfeld verwendet, sondern nur gezielt Strahlung für die Pixel P1-P3 erfasst. Das Aufnehmen mit gezielt eingeschränktem zweiten Sichtfeld kann dabei hintereinander für die einzelnen Bildpunkte bzw. Regions of Interest erfolgen (also Sichtfeld erst auf/um Bildpunkt P1 ausrichten, dann auf Bildpunkt P2 usw.). Die zweite Bilderrate R2 ist dabei wie angedeutet wesentlich höher als die erste Bilderrate R1.

Die aus den Differenzbildern 21 für ein jeweiliges Pixel P1-P3 abgeleitete Intensität I wird dann im Hinblick auf die Signaturen 4, 6 analysiert (dargestellt im unteren Teil der Figur 3b). Im Beispiel wird dabei Übereinstimmung der Intensität I des Bildpunkts P1 mit der Signatur 4 festgestellt und Übereinstimmung der Intensität I des Bildpunkts P2 mit der Signatur 6 (Wert jeweils über einem definierten Schwellwert T). P1 ist also als zur Signatur 4 gehörig erkannt bzw. das (Gesamt-)Signal des Bildpunkts P1 als durch die Signatur 4 verursacht und entsprechend P2 der Signatur 6 zugeordnet. Es ist somit mit dem Bildpunkt P1 Strahlung der Zielmarke 3 (vgl. Figur 1) identifiziert und mit dem Bildpunkt P2 Strahlung der Zielmarke 5.

Für den Bildpunkt P3 wird dagegen keine Übereinstimmung des Intensitätssignals I mit einer der beiden hinterlegten Signaturen 4 oder 6 ermittelt (Wert sowohl hinsichtlich Signatur 4 als auch Signatur 6 unterhalb des Grenzwerts T). Somit konnte mit der zweiten "feineren" Teststufe, welche auf der zweiten Bildsequenz basiert, dieses Sensorsignal des Bildpunkts P3 als Artefakt "ausgesiebt" werden.

Die Figuren 3a, 3b stellen also ein weiteres Beispiel für das erfindungsgemässe Vorgehen dar, in dem zuerst mit einem grossen Sichtfeld ein weiter Messumgebungsbereich abgedeckt wird und eine "Vorprüfung" hinsichtlich Zielmarkenstrahlung mit vergleichsweise wenigen Bildern 19 erfolgt, um dann die übriggebliebenen Ausschnitte der Messumgebung gezielt mit hoher zeitlicher Abdeckung durch eine dichte Bilderfolge 20 robust zu prüfen.

Das Verwenden von Differenzbildern 21 bei Verwendung einer phasencodierten Signatur 4, 6 hat den Vorteil, dass damit auch ohne vorausgegangene Synchronisation eine Analyse hinsichtlich Zielsignatur möglich ist, wobei optional eine jeweilige Signatur 4, 6 einen Start- und/oder Endpointer aufweist, welcher Beginn und/oder Ende der Signatur indiziert, z.B. nach Art sog. "Framing-Bits". Damit ist es z.B. nicht notwendig, dass das Aufnehmen der ersten und/oder zweiten Bildersequenz und das Emittieren der Zielmarkenstrahlung bzw. der Signaturen 4, 6 synchronisiert gestartet werden bzw. allgemeiner ausgedrückt, entfällt mit dem vorgeschlagenen Verfahren die Notwendigkeit einer aufwändigen Kommunikation zwischen Zielmarke und Zielmarkenfinder. Wird z.B. das Emittieren der Zielmarkenstrahlung wie weiter oben genannt manuell gestartet, kann sogar jegliche Kommunikation zwischen Zielmarke und Zielmarkenfinder entfallen. Ausserdem können so Bitfehler durch leicht unterschiedliche Clockfrequenzen der Zielmarke und des Empfängers rein auf der Empfängerseite ohne Kommunikation zwischen beiden behoben werden.

Wie in den Figur 3a und 3b unten dargestellt, wird dabei gemäss der jeweiligen Bildrate R1, R2 für die erste Teststufe (Figur 3a) vor allem oder ausschliesslich der "niederfrequente" Anteil 4a, 6a der Signatur 4, 6 zum Test herangezogen, dagegen in der zweiten Teststufe (Figur 3b) der "hochfrequente" Anteil 4b, 6b der Signatur 4, 6.

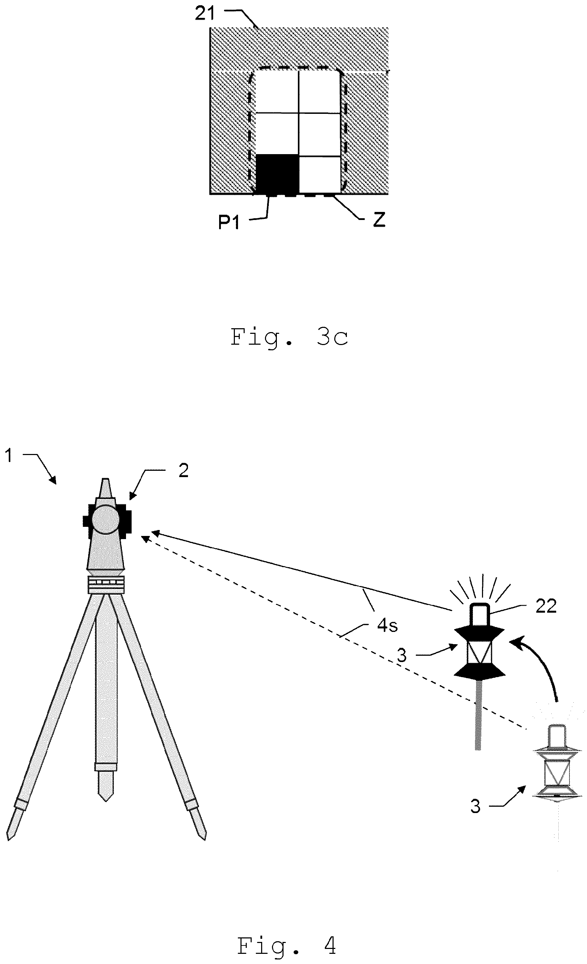

Wie in Figur 3c schematisch dargestellt, beschränkt sich das zweite Sichtfeld Z abweichend zu der stark vereinfachten Darstellung der Figur 3b vorzugsweise nicht nur auf einen anhand der ersten Bildersequenz identifizierten Bildpunkt P1, sondern umfasst einen Bereich Z bzw. eine Anzahl von Pixel um diesen herum. Wie im Beispiel dargestellt, muss dabei der identifizierte Bildpunkt P1 nicht im Zentrum des Bereichs liegen sowie das zweite Sichtfeld Z nicht quadratisch sein.

Z.B. wird im Falle bewegter Zielmarken optional anhand der ersten Bildersequenz für eine jeweilige erfasste Strahlung eine Bewegungsrichtung und auch Geschwindigkeit bestimmt und die Lage und Grösse (Form) des Sichtfelds anhand dieser Kenngrössen adaptiert. Ist z.B. die ermittelte Zielmarkengeschwindigkeit relativ gross, wird auch das Sichtfeld relativ gross eingestellt, bewegt sich die Strahlung auf dem Sensor nach "oben", wird das Sichtfeld um den Pixel P1 wie dargestellt nach "oben" erweitert bzw. verschoben. Somit wird das zweite Sichtfeld auf die Bewegung der Strahlungsquelle/Zielmarke optimal eingestellt.

Figur 4 zeigt eine weitere Fortbildung des Verfahrens. Im Beispiel wird die Lage derjenigen jeweiligen Bildpunkte, welche im Schritt 17 (vgl. Figur 2) als Bildpunkte einer Zielmarke 3 eindeutig identifiziert sind, genutzt, um eine Richtung zur jeweiligen Zielmarke 3 zu ermitteln, z.B. in Form von Polar- und Azimutwinkel (wobei das Richtungsbestimmen nicht erst nach dem Schritt 17 erfolgen kann, sondern z.B. auch im Anschluss an das Identifizieren potentieller Zielmarkenpixel; s. Schritt 12 in Figur 2). Es ist also beispielsweise die Auswerteeinheit des Vermessungsgeräts 1 (s. Figur 1) ausgebildet, anhand der Position des identifizierten Bildpunkts eine Richtung zur Zielmarke zu ermitteln. Dies wird optional genutzt, um beispielsweise anhand einer Ablage des Bildpunkts von einer zentralen Bildpunkt-/Sensorposition (ein Nullpunkt des Bildsensors) eine Ausrichtung des Zielmarkenfinders 2 bzw. Vermessungsgeräts 1 so zu steuern, dass die Ablage korrigiert wird. Mit anderen Worten kann anhand der optional ermittelten Richtung zum Ziel 3 das Vermessungsgerät 1 zentral auf die Zielmarke 3 ausgerichtet werden.

Alternativ oder zusätzlich wird im Falle einer sich bewegenden Zielmarke 3 die Lage bzw. die Lagen des betreffenden Bildpunkts auf dem Sensor genutzt, um die bewegte Zielmarke 3 fortlaufend zu verfolgen, wobei anhand der zeitlichen Änderung der Bildpunktposition auch eine (zumindest grobe) Geschwindigkeit der Zielmarke, zumindest normal zur Blickrichtung, ermittelt wird. Der Zielauffinder 2 dient in diesen Ausführungsformen somit nicht nur zum Zielauffinden, sondern auch zum Tracken der Zielmarke 3. Vor allem bei einem Zielauffinder 2 mit sehr grossem Sichtfeld (Overviewkamera) ist es auch möglich, gleichzeitig mehrere Zielmarken 3 zu verfolgen, bzw. sehr rasch zwischen der Verfolgung mehrerer Zielmarken 3 zu wechseln, selbst dann, wenn diese sich in verschiedene Richtungen bewegen.

Obige Figuren stellen nur mögliche Ausführungsbeispiele schematisch dar. Die verschiedenen Ansätze können -soweit nicht anders vermerkt- ebenso miteinander sowie mit bekannten Verfahren und Geräten kombiniert werden.

## Patentansprüche

1. Verfahren (7) zum automatischen Auffinden von wenigstens einer Zielmarke (3, 5) mit
▪ Emittieren von Strahlung (4s, 6s) von der Zielmarke (3, 5), wobei die Strahlung (4s, 6s) mittels Modulation, insbesondere Phasenmodulation, wiederkehrend eine charakteristische Signatur (4, 6) aufweist,
▪ Aufnehmen (8) einer ersten Bildersequenz (18) mit einer ersten Bildrate (R1), **gekennzeichnet durch**
▪ statistisches Auswerten (9, 10) der ersten Bildersequenz (18) in Kenntnis der Signatur (4, 6) mit Bestimmen einer Gütefunktion (G), wobei der Wert der Gütefunktion (G) eine Wahrscheinlichkeit dafür angibt, dass in einem jeweiligen Bildpunkt (P1-P4) Zielmarkenstrahlung (4s, 6s) erfasst ist, und
▪ Identifizieren (12) von Bildpunkten (P1-P3), mit denen wahrscheinlich Zielmarkenstrahlung (4s, 6s) erfasst ist, basierend auf dem zugehörigen Wert der Gütefunktion (G),
▪ Aufnehmen (13) einer zweiten Bildersequenz (20) mit einer zweiten, zur ersten Bildrate (R1) unterschiedlichen Bildrate (R2),
▪ Auswerten (14) von Intensitätssignalen (I) der zweiten Bildersequenz (20) für besagte identifizierte Bildpunkte (P1-P3) und
▪ Identifizieren (15, 17) der Zielmarkenstrahlung (4s, 6s) anhand der Intensitätssignale (I) basierend auf der Signatur (4, 6).

2. Verfahren (7) nach Anspruch 1,
**dadurch gekennzeichnet, dass**
das Aufnehmen (13) der zweiten Bildersequenz (20) mit mindestens einem zweiten Sichtfeld (P1-P3, Z) erfolgt, welches kleiner ist als ein erstes Sichtfeld des Aufnehmens (8) der ersten Bildersequenz (18), wobei sich eine Lage des mindestens einen zweiten Sichtfelds (P1-P3, Z) nach dem jeweiligen identifizierten Bildpunkt (P1-P3) richtet.

3. Verfahren (7) nach Anspruch 1 oder 2,
**dadurch gekennzeichnet, dass**
die Signatur (4, 6)
▪ einen ersten, auf die erste Bildrate (R1) abgestimmten, Anteil (4a, 4b) und einen zweiten, auf die zweite Bildrate (R2) abgestimmten Anteil (4b, 6b) aufweist, und/oder
▪ einen Start- und/oder Endindikator aufweist.

4. Verfahren (7) nach einem der vorherigen Ansprüche, **dadurch gekennzeichnet, dass**
die zweite Bildrate (R2) mindestens zehnmal so hoch ist wie die erste Bildrate (R1), insbesondere wobei die erste Bildrate (R1) im Bereich zwischen 45Hz und 65Hz liegt und/oder die zweite Bildrate (R2) mindestens 1kHz beträgt.

5. Verfahren (7) nach einem der vorherigen Ansprüche, **dadurch gekennzeichnet, dass**
das Aufnehmen (8, 13) der ersten und zweiten Bildersequenz (18, 20) synchronisationslos zum Emittieren der Zielmarkenstrahlung (4s, 6s) oder über einen separaten, unabhängigen Kommunikationskanal synchronisiert erfolgt.

6. Verfahren (7) nach einem der vorherigen Ansprüche,
**dadurch gekennzeichnet, dass**
das Auswerten (9, 10, 14) der ersten und/oder zweiten Bildersequenz (18, 20) mittels Differenzbildern (19, 21) erfolgt.

7. Verfahren (7) nach einem der vorherigen Ansprüche,
**dadurch gekennzeichnet, dass**
das Aufnehmen (8, 13) der ersten und/oder zweiten Bildersequenz (18, 20) über eine Zeitdauer erfolgt, in welcher die Signatur (4, 6) vielfach wiederholend emittiert wird.

8. Verfahren (7) nach einem der vorherigen Ansprüche,
**dadurch gekennzeichnet, dass**
die Gütefunktion (G) von der ersten Bildrate (R1), und insbesondere einer Frequenz der Modulation, abhängig ist.

9. Verfahren (7) nach einem der vorherigen Ansprüche,
**dadurch gekennzeichnet, dass**
▪ im Rahmen des Verfahrens (7) anhand der identifizierten Zielmarkenstrahlung (4s, 6s) eine automatische Verfolgung der Zielmarke (3, 5) erfolgt und/oder
▪ mittels der ersten und/oder zweiten Bildersequenz (18, 20) anhand identifizierter Bildpunkte (P1-P3) eine Richtung zur Zielmarke (3, 5) bestimmt wird.

10. Zielmarkenfinder (2) mit einer Auswerteelektronik und einem ortsauflösenden optoelektronischen Sensor, insbesondere ausgebildet als CCD- oder CMOS-Sensor, zweidimensionaler Photodetektorenarray oder Dynamic Vision Sensor, zur Erfassung von eine bekannte charakteristische Signatur (4, 6) aufweisender Zielmarkenstrahlung (4s, 6s), wobei der Zielmarkenfinder (2) ausgebildet
▪ mittels des Sensors eine erste Bildersequenz (18) mit einer ersten Bildrate (R1) aufzunehmen
**dadurch gekennzeichnet, dass** der Zielmarkenfinder weiter ausgebildet ist,
▪ mittels der Auswerteelektronik
o die erste Bildersequenz (18) statistisch auszuwerten, wobei eine Gütefunktion (G) bestimmt wird, deren Wert eine Wahrscheinlichkeit dafür angibt, dass in einem jeweiligen Bildpunkt (P1-P4) Zielmarkenstrahlung (4s, 6s) erfasst wozu in der Auswerteelektronik die Signatur (4, 6) hinterlegt und
o basierend auf dem zugehörigen Wert der Gütefunktion (G) Bildpunkte (P1-P3) zu identifizieren, mit denen wahrscheinlich Zielmarkenstrahlung (4s, 6s) erfasst
▪ mittels des Sensors eine zweite Bildersequenz (20) mit einer zweiten, zur ersten Bildrate (R1) unterschiedlichen Bildrate (R2) aufzunehmen und
▪ mittels der Auswerteelektronik
∘ Intensitätssignale (I) der zweiten Bildersequenz (20) für besagte identifizierte Bildpunkte (P1-P3) auszuwerten und
∘ Zielmarkenstrahlung (4s, 6s) anhand der Intensitätssignale (I) basierend auf der Signatur (4, 6) zu identifizieren.

11. Zielmarkenfinder (2) nach Anspruch 10,
**dadurch gekennzeichnet, dass**
der Zielmarkenfinder (2)
▪ einen abschaltbaren Langpassfilter und/oder
▪ ein nahinfrarotkorrigiertes Objektiv aufweist und/oder
▪ der Sensor Teil einer Überblickskamera ist.

12. Zielmarkenfinder (2) nach Anspruch 10 oder 11,
**dadurch gekennzeichnet, dass**
die Auswerteelektronik ausgebildet ist, anhand einer Position eines identifizierten Bildpunkts (P1-P3) auf dem Sensor eine Richtung zur Zielmarke (3, 5) zu ermitteln.

13. Vermessungssystem mit einem Zielmarkenfinder (2) nach Anspruch 10 und einer Zielmarke (3, 5) mit einer modulierbaren Strahlquelle (22), vorgesehen zur Emission von Zielmakenstrahlung (4s, 6s), wobei die Zielmarkenstrahlung mittels Modulation wiederkehrend eine charakteristische Signatur (4,6) aufweist.

14. Computerprogrammprodukt mit Programmcode, der auf einem maschinenlesbaren Träger gespeichert ist, als festverdrahtete Logik ausgebildet ist oder als Computerdatensignal verkörpert durch eine elektromagnetische Welle ausgebildet ist, zur Durchführung des Verfahrens (7) nach Anspruch 1 auf einem Zielmarkenfinder (2) nach Anspruch 10.

## Claims

1. Method (7) for automatically locating at least one target marker (3, 5), having
▪ emission of radiation (4s, 6s) by the target marker (3, 5), wherein by means of modulation, in particular phase modulation, the radiation (4s, 6s) recurrently has a characteristic signature (4, 6),
▪ recording (8) a first image sequence (18) with a first frame rate (R1),
**characterized by**
▪ statistically evaluating (9, 10) the first image sequence (18) by reference to the signature (4, 6) with determination of a quality function (G), wherein the value of the quality function (G) specifies a probability that target marker radiation (4s, 6s) is detected in a respective pixel (P1-P4), and
▪ identifying (12) pixels (P1-P3) with which target marker radiation (4s, 6s) is likely detected, based on the associated value of the quality function (G),
▪ recording (13) a second image sequence (20) with a second frame rate (R2), different from the first frame rate (R1),
▪ evaluating (14) intensity signals (I) of the second image sequence (20) for said identified pixels (P1-P3) and
▪ identifying (15, 17) the target marker radiation (4s, 6s) using the intensity signals (I) on the basis of the signature (4, 6).

2. Method (7) according to Claim 1,
**characterized in that**
the recording (13) of the second image sequence (20) is carried out with at least one second field of view (P1-P3, Z) which is smaller than a first field of view of the recording (8) of the first image sequence (18), wherein a position of the at least one second field of view (P1-P3, Z) corresponds to the respective identified pixel (P1-P3).

3. Method (7) according to Claim 1 or 2,
**characterized in that**
the signature (4, 6) has
▪ a first component (4a, 4b) adjusted to the first frame rate (R1), and a second component (4b, 6b) adjusted to the second frame rate (R2), and/or
▪ a start and/or end indicator.

4. Method (7) according to any one of the preceding claims,
**characterized in that**
the second frame rate (R2) is at least ten times as high as the first frame rate (R1), in particular wherein the first frame rate (R1) is in the range between 45Hz and 65Hz and/or the second frame rate (R2) is at least 1kHz.

5. Method (7) according to any one of the preceding claims,
**characterized in that**
the recording (8, 13) of the first and second image sequence (18, 20) is not synchronized with the emission of the target marker radiation (4s, 6s) or is synchronized via a separate, independent communication channel.

6. Method (7) according to any one of the preceding claims,
**characterized in that**
the evaluation (9, 10, 14) of the first and/or second image sequence (18, 20) is carried out by means of difference images (19, 21).

7. Method (7) according to any one of the preceding claims,
**characterized in that**
the recording (8, 13) of the first and/or second image sequence (18, 20) takes place over a period in which the emission of the signature (4, 6) is repeated multiple times.

8. Method (7) according to any one of the preceding claims,
**characterized in that**
the quality function (G) is dependent on the first frame rate (R1), and in particular on a frequency of the modulation.

9. Method (7) according to any one of the preceding claims,
**characterized in that**
▪ in the context of the method (7) an automatic tracking of the target marker (3, 5) is carried out on the basis of the identified target marker radiation (4s, 6s) and/or
▪ by means of the first and/or second image sequence (18, 20), on the basis of identified pixels (P1-P3) a direction to the target marker (3, 5) is determined.

10. Target marker locator (2) having an evaluation electronics and a spatially-resolving optoelectronic sensor, in particular, designed as a CCD or CMOS sensor, two-dimensional photodetector array or dynamic vision sensor, for detecting target marker radiation (4s, 6s) having a known characteristic signature (4, 6), wherein the target marker locator (2) is designed,
▪ by means of the sensor, to record a first image sequence (18) with a first frame rate (R1),
**characterized in that** the target marker locator is further designed
▪ by means of the evaluation electronics
o to statistically evaluate the first image sequence (18), wherein a quality function (G) is determined, the value of which indicates a probability that target marker radiation (4s, 6s) is detected in a respective pixel (P1-P4), for which purpose the signature (4, 6) is stored in the evaluation electronics, and
o based on the associated value of the quality function (G) to identify pixels (P1-P3) with which target marker radiation (4s, 6s) is likely detected,
▪ by means of the sensor, to record a second image sequence (20) with a second frame rate (R2) different from the first frame rate (R1),
▪ by means of the evaluation electronics
o to evaluate intensity signals (I) of the second image sequence (20) for said identified pixels (P1-P3), and
o to identify target marker radiation (4s, 6s) from the intensity signals (I) based on the signature (4, 6) .

11. Target marker locator (2) according to Claim 10,
**characterized in that**
the target marker locator (2)
▪ has a long-pass filter that can be switched off and/or
▪ a near-infrared-corrected lens and/or
▪ the sensor is part of an overview camera.

12. Target marker locator (2) according to Claim 10 or 11,
**characterized in that**
the evaluation electronics is designed to determine a direction to the target marker (3, 5) based on a position of an identified pixel (P1-P3) on the sensor.

13. Surveying system having a target marker locator (2) according to Claim 10 and a target marker (3, 5) having a modulatable beam source (22) designed for emitting target marker radiation (4s, 6s), wherein by means of modulation the target marker radiation (4s, 6s) recurrently has a characteristic signature (4, 6).

14. Computer program product with program code, which is stored on a machine-readable medium, is implemented as hard-wired logic or as a computer data signal, embodied by an electromagnetic wave, for carrying out the method (7) according to Claim 1 on a target marker locator (2) according to Claim 10.

## Revendications

1. Procédé (7) de recherche automatique d'au moins une marque cible (3, 5) avec
▪ émission de rayonnement (4s, 6s) par la marque cible (3, 5), dans lequel le rayonnement (4s, 6s) comporte périodiquement une signature caractéristique (4, 6) au moyen d'une modulation, en particulier d'une modulation de phase,
▪ capture (8) d'une première séquence d'images (18) avec une première fréquence de trame (R1),
**caractérisé par**
▪ analyse statistique (9, 10) de la première séquence d'images (18) compte tenu de la signature (4, 6) avec détermination d'une fonction de puissance statistique (G), dans lequel la valeur de la fonction de puissance statistique (G) indique une probabilité que du rayonnement de marque cible (4s, 6s) soit saisi dans un point d'image respectif (P1-P4), et
▪ identification (12) de points d'image (P1-P3) avec lesquels du rayonnement de marque cible (4s, 6s) est probablement saisi, sur la base de la valeur associée de la fonction de puissance statistique (G),
▪ capture (13) d'une deuxième séquence d'images (20) avec une deuxième fréquence de trame (R2) différente de la première fréquence de trame (R1),
▪ analyse (14) de signaux d'intensité (I) de la deuxième séquence d'images (20) pour les dits points d'image identifiés (P1-P3) et
▪ identification (15, 17) du rayonnement de marque cible (4s, 6s) à l'aide des signaux d'intensité (I) sur la base de la signature (4, 6).

2. Procédé (7) selon la revendication 1,
**caractérisé en ce que**
la capture (13) d'une deuxième séquence d'images (20) s'effectue avec au moins un deuxième champ de vision (P1-P3, Z), lequel est plus petit qu'un premier champ de vision de la capture (8) de la première séquence d'images (18), dans lequel une position de l'au moins un deuxième champ de vision (P1-P3, Z) dépend du point d'image identifié respectif (P1-P3).

3. Procédé (7) selon la revendication 1 ou 2,
**caractérisé en ce que**
la signature (4, 6)
▪ comporte une première partie (4a, 4b) adaptée à la première fréquence de trame (R1) et une deuxième partie (4b, 6b) adaptée à la deuxième fréquence de trame (R2), et/ou
▪ comporte un indicateur de début et/ou de fin.

4. Procédé (7) selon l'une des revendications précédentes,
**caractérisé en ce que**
la deuxième fréquence de trame (R2) est au moins dix fois plus élevée que la première fréquence de trame (R1), en particulier dans lequel la première fréquence de trame (R1) se trouve dans un intervalle compris entre 45 Hz et 65 Hz et/ou la deuxième fréquence de trame (R2) est d'au moins 1 kHz.

5. Procédé (7) selon l'une des revendications précédentes,
**caractérisé en ce que**
la capture (8, 13) de la première et de la deuxième séquence d'images (18, 20) s'effectue sans synchronisation pour l'émission du rayonnement de marque cible (4s, 6s) ou s'effectue de manière synchronisée par le biais d'un canal de communication séparé et indépendant.

6. Procédé (7) selon l'une des revendications précédentes,
**caractérisé en ce que**
l'analyse (9, 10, 14) de la première et de la deuxième séquence d'images (18, 20) s'effectue au moyen d'images différentielles (19, 21).

7. Procédé (7) selon l'une des revendications précédentes,
**caractérisé en ce que**
la capture (8, 13) de la première et/ou de la deuxième séquence d'images (18, 20) s'effectue sur une période de temps durant laquelle la signature (4, 6) est émise à plusieurs reprises.

8. Procédé (7) selon l'une des revendications précédentes,
**caractérisé en ce que**
la fonction de puissance statistique (G) dépend de la première fréquence de trame (R1), et en particulier d'une fréquence de la modulation.

9. Procédé (7) selon l'une des revendications précédentes,
**caractérisé en ce que**
▪ dans le cadre du procédé (7), un suivi automatique de la marque cible (3, 5) s'effectue à l'aide du rayonnement de marque cible (4s, 6s) identifié et/ou
▪ au moyen de la première et/ou de la deuxième séquence d'images (18, 20), une direction vers la marque cible (3, 5) est déterminée à l'aide des points d'image identifiés (P1-P3).

10. Détecteur de marque cible (2) doté d'une électronique d'analyse et d'un capteur optoélectronique résolu spatialement, en particulier réalisé comme capteur CCD ou CMOS, réseau bidimensionnel de photodétecteurs ou capteur de vision dynamique, destiné à saisir un rayonnement de marque cible (4s, 6s) comportant une signature caractéristique connue (4, 6), dans lequel le détecteur de marque cible (2) est réalisé
▪ pour capturer une première séquence d'images (18) avec une première fréquence de trame (R1) au moyen du capteur,
**caractérisé en ce que** le détecteur de marque cible est en outre réalisé pour,
▪ au moyen de l'électronique d'analyse
o analyser statistiquement la première séquence d'images (18), dans lequel une fonction de puissance statistique (G) est déterminée, dont la valeur indique une probabilité que du rayonnement de marque cible (4s, 6s) soit saisi dans un point d'image respectif (P1-P4), la signature (4, 6) étant enregistrée dans l'électronique d'analyse à cet effet, et
o identifier les points d'image (P1-P3) avec lesquels avec lesquels du rayonnement de marque cible (4s, 6s) est probablement saisi, sur la base de la valeur associée de la fonction de puissance statistique (G),
▪ capturer une deuxième séquence d'images (20) avec une deuxième fréquence de trame (R2) différente de la première fréquence de trame (R1) et
▪ au moyen de l'électronique d'analyse
o analyser les signaux d'intensité (I) de la deuxième séquence d'images (20) pour les dits points d'image identifiés (P1-P3) et
∘ identifier du rayonnement de marque cible (4s, 6s) à l'aide des signaux d'intensité (I) sur la base de la signature (4, 6).

11. Détecteur de marque cible (2) selon la revendication 10,
**caractérisé en ce que**
le détecteur de marque cible (2)
▪ comporte un filtre laissant passer les grandes longueurs d'onde et/ou
▪ un objectif corrigé dans l'infrarouge proche et/ou
▪ est la partie de capteur d'une caméra d'observation.

12. Détecteur de marque cible (2) selon la revendication 10 ou 11,
**caractérisé en ce que**
l'électronique d'analyse est réalisée pour déterminer une direction vers la marque cible (3, 5) à l'aide des points d'image identifiés (P1-P3).

13. Système de mesure avec un détecteur de marque cible (2) selon la revendication 10 et une marque cible (3, 5) avec une source de rayonnement modulable (22), prévue pour émettre du rayonnement de marque cible (4s, 6s), dans lequel le rayonnement de marque cible (4s, 6s) comporte périodiquement une signature caractéristique (4, 6) au moyen d'une modulation.

14. Produit-programme informatique doté de code de programmation, lequel est enregistré sur un support lisible par machine, est réalisé comme logique câblée ou comme signal de données informatiques incarné par une onde électromagnétique, destiné à la mise en œuvre du procédé (7) selon la revendication 1 sur un détecteur de marque cible (2) selon la revendication 10.
